# EUROPÄISCHE PATENTSCHRIFT

(11) **EP 2 567 926 B1**
(45) Veröffentlichungstag und Bekanntmachung des Hinweises auf die Patenterteilung: **09.10.2013**
(21) Anmeldenummer: 11008338.3
(22) Anmeldetag: 17.10.2011
(51) Int. Cl.: B66B 13/22, H03K 17/968

(54) **Schaltungseinrichtung, Sicherungsvorrichtung sowie Aufzugvorrichtung**
Circuit device, safety device and lift device
Dispositif de commutation, dispositif de sécurisation et dispositif d'ascenseur

(30) Priorität: 06.09.2011 EP 11007224
(43) Veröffentlichungstag der Anmeldung: 13.03.2013
(73) Patentinhaber: Cedes AG, 7302 Landquart (CH)
(72) Erfinder: De Coi, Beat, 7320 Sargans (CH); Leutenegger, Tobias, 7000 Chur (CH); Hersche, Dumeng, 7402 Bonaduz (CH); Hegelbach, Jürg, 9463 Oberriet (CH)
(74) Vertreter: Roth, Klaus

(56) Entgegenhaltungen:
- EP-A1- 0 905 901
- DE-A1-102009 037 347
- GB-A- 876 371

## Beschreibung

Die Erfindung betrifft eine Schaltungseinrichtung nach dem Oberbegriff des Anspruchs 1, eine Sicherungsvorrichtung für Aufzugvorrichtungen nach dem Oberbegriff des Anspruchs 8 sowie eine für Aufzugvorrichtungen nach dem Oberbegriff des Anspruchs 9.

Bekannt sind aus dem Stand der Technik handelsübliche Sicherungsvorrichtungen für Aufzüge, welche elektrische bzw. elektromechanische Kontakte und Schalter verwenden, um den verriegelungs- bzw. Schließzustand einer Aufzugstür zu bestimmen. Die Fahrt einer Aufzugkabine soll dabei nur zugelassen werden, wenn sämtliche Türen verriegelt sind.

DE 10 2009 037 347 offenbart eine Sicherungsvorrichtung umfassend einen Sicherheitscontroller und einen bus.

Aufgabe der Erfindung ist es, eine Schaltungsvorrichtung, eine Sicherungsvorrichtung sowie eine Aufzugvorrichtung vorzuschlagen, die eine verbesserte Ortung der Schaltzustände von Sensoren ermöglicht.

Die Aufgabe wird, ausgehend von einer Schaltungseinrichtung, Sicherungsvorrichtung sowie eine Aufzugvorrichtung der eingangs genannten Art, durch die kennzeichnenden Merkmale der Ansprüche 1, 8 und 9 gelöst.

Durch die in abhängigen Ansprüchen genannten Maßnahmen sind vorteilhafte Weiterbildungen und Ausführungen der Erfindung möglich.

Dementsprechend zeichnet sich eine Schaltungseinrichtung, welche wenigstens einen Sensor zur Detektion umfasst, welcher in Abhängigkeit von der Detektion zwischen wenigstens zwei Schaltzuständen schaltbar ist, dadurch aus, dass eine Schalteinheit vorgesehen, wobei die Schalteinheit und der wenigstens eine Sensor jeweils eine Kommunikationseinheit zur Kommunikation untereinander aufweisen.

Ferner kann bei einem Sensor die Kommunikation über eine Modulation seines Eigenwiderstandes des Sensors erfolgen. Im Stromkreis mit der Schalteinheit kann dadurch je nach Schaltung die Spannung und/oder der Stromstärke moduliert werden. Diese Modulation trägt dann die Information, die bei der Kommunikation übertragen werden soll. Denkbar ist z.B, ein Stromkreis, der in Reihe geschaltete Sensoren und (ebenfalls in Reihe geschaltet) eine Schalteinheit umfasst. Wird grundsätzlich der Widerstand eines Sensors bei in Reihe geschalteten Sensoren verändert, so ändert sich die Stromstärke gemäß dem Ohm'schen Gesetz. Wird dann eine Konstantstromquelle für den Stromkreis verwendet, so bewirkt eine Änderung des Widerstandes, dass die Spannung erhöht werden muss, um die sich ergebende Abnahme der Stromstärke, die durch den geringeren Widerstand zunächst verursacht wird, auszugleichen. Die Änderungen von Stromstärke bzw. Spannung und Widerstand sind messbar und können als Information interpretiert werden.

Die Schalteinheit wiederum ist in Abhängigkeit der Sensoren schaltbar. Die Information, in welchen Schaltzustand die Schalteinheit schalten soll, wird über die Kommunikationseinheiten übertragen.

Bei herkömmlichen Schalteinrichtungen und Sicherheitseinrichtungen aus dem Stand der Technik war mitunter nicht möglich, beispielsweise bei Verwendung in Reihe geschalteter Öffnungsschalter herauszufinden, welcher Schalter unterbrochen ist, eine Defekt aufweist oder dergleichen. Zudem bedeutet ein geöffneter Öffnungsschalter eine Leitungsunterbrechung. Beim erfindungsgemäßen Einsatz der Sensoren und der Schalteinheit muss jedoch die Leitung nicht unterbrochen werden. Zudem kann jeder Sensor individuell mit der Schalteinheit kommunizieren und Informationen übermitteln bzw. austauschen.

Die Änderung eines Widerstandes kann durch Hinzuschalten weiterer Widerstände erfolgen, aber auch z.B. durch Sperren von Transistoren oder dergleichen.

Die Schalteinheit wiederum ist bei einer Weiterbildung der Erfindung dazu ausgebildet, die Kommunikation mit den Sensoren durch Modulation der Stromstärke bzw. der Spannung durchzuführen. Diese Maßnahme kann durch Änderungen von Widerständen oder entsprechenden Änderungen bzw. Anpassungen von Spannung oder Stromstärke erfolgen. Besonders vorteilhaft kann sich diese Maßnahme in Bezug auf die Nachrüstbarkeit der Schaltungseinrichtung auswirken. Bei der bereits angesprochenen Verwendung von Öffnungsschaltern aus dem Stand der Technik ist regelmäßig eine Leitung vorhanden, bei der die Öffnungsschalter in Serie geschaltet sind. Wird eine solche Einrichtung ausgetauscht gegen die erfindungsgemäße Schaltungseinrichtung, so ist es weiterhin nur notwendig, ein einziges Kabel einzuziehen, da der Informationsaustausch bzw. die Kommunikation zwischen den Sensoren und der Schalteinheit nur über eine einzige Leitung erfolgen muss. Träger der Information ist z.B. die Änderung der Stromstärke in der Leitung oder bei Anpassung der Stromstärke z.B. die Änderung der abfallenden Spannung.

Die Parallelschaltung zweier Konstantstromquellen ermöglicht es ebenfalls, die Stromstärke zu erhöhen. Sind beispielsweise bei konstantem widerstand zwei Spannungsquellen mit gleicher Spannung parallel geschaltet, so addieren sich die Stromstärken der durch die Stromquellen fließenden Ströme. Ausgangspunkt sei eine Konstantstromquelle, die an genannten Widerstand angeschlossen wird. Anschließend wird die gleiche Konstantstromquelle parallel zur ersten hinzugeschaltet. Da es sich aber um Konstantstromquellen handelt, verdoppeln diese ihre Spannung jeweils, um bei konstantem Widerstand wiederum die gleiche Stromstärke zu liefern.

Bei einer bevorzugten Weiterbildung der Erfindung ist ferner eine Messeinheit vorgesehen, mit der die Modulationen gemessen werden können. Aus der Messung der Modulation ermittelt die Messeinheit die Information, die bei der Kommunikation übermittelt werden. Die Messeinheit kann insbesondere als Spannungsmessgerät bzw. Voltmeter ausgebildet sein. Bei bekanntem Widerstand kann aus der abgefallenen Spannung auch die Stromstärke oder bei konstanter Stromstärke entsprechend auch der Widerstand bestimmt werden.

Denkbar ist ein Ausführungsbeispiel einer Schaltungseinrichtung, bei der wenigstens einer der Sensoren und die Schalteinheit dazu ausgebildet sind, die Informationsübertragung zwischen dem wenigstens einen Sensoren und der Schalteinheit wechselseitig durch Modulation der Stromstärke und durch Modulation der Spannung vorzunehmen. Zudem ist denkbar, dass wenigstens einer der Sensoren und die Schalteinheit dazu ausgebildet sind, die Informationsübertragung von den wenigstens einem Sensoren zur Schalteinheit durch Modulation der Spannung vorzunehmen und die Informationsübertragung von der Schalteinheit zu den wenigstens einen Sensoren durch Modulation der Stromstärke vorzunehmen. Somit kann in vorteilhafter Weise die Information mit codiert werden, welches Bauteil gerade Informationen sendet.

Eine erfindungsgemäße Sicherungsvorrichtung für Aufzugvorrichtungen, die über einen Antrieb eine Kabine verfahren können, mit einem Sicherheitskreis und einer Unterbrechungsvorrichtung zum Unterbrechen des Antriebs in Abhängigkeit vom Leitungszustand des Sicherheitskreises, zeichnet sich dadurch aus, dass eine erfindungsgemäße Schaltungseinrichtung vorgesehen ist und die Sensoren in Abhängigkeit vom Schließzustand der Aufzugstür zwischen wenigstens zwei Schaltzuständen schaltbar sind, und wobei die Schalteinheit in Abhängigkeit vom Schaltzustand der Sensoren den zwischen einem geschlossenen und einem geöffneten Leitungszustand schaltbar ist.

Ebenfalls zeichnet sich eine erfindungsgemäße Aufzugvorrichtung mit einer Kabine und wenigstens einer Aufzugtür zum Öffnen und/oder Verschließen der Kabine sowie mit einer Sicherungsvorrichtung zur Verriegelung der Aufzugtür während des Betriebes, dadurch aus, dass eine erfindungemäße Sicherungsvorrichtung vorhanden ist.

Wie bereits erwähnt kann eine separate Auswerteeinheit vorgesehen sein, welche beispielsweise über eine Schnittstelle mit dem entsprechenden Bus kommunizieren kann. Besonders vorteilhaft ist an der Vorrichtung, dass keine Unterbrechung eines elektrischen Kontaktes vorgesehen ist, sondern lediglich eine Übermittelung eines Signals auf optischem Wege ermöglicht oder verhindert wird.

Ein weiterer Vorteil besteht darin, dass die Vorrichtung besonders gut nachrüstbar ist. Bei einem bestehenden Aufzugsystem war es bislang besonders nachteilig, dass beim Defekt eines Sensors praktisch alle Sensoren in den einzelnen Stockwerken separat diesbezüglich untersucht werden müssen. Zudem ist gegebenenfalls nicht zu erkennen, ob es sich um den Defekt eines einzelnen Sensors oder mehrere Sensor handelt, sodass gegebenenfalls alle Sensoren überprüft werden müssen. Die Zustände der Sensor, d, h. defekt oder nicht bzw. geöffnet oder nicht, können über eine Auswerteeinheit auch bequem an einem Rechner, Bedienpult oder Ähnlichem zentral angezeigt werden.

Bei einem entsprechenden Nachrüstverfahren ist kann die Sicherheitseinrichtung als Austauschteil verwendet werden. Die Verbindung zu den Öffnungsschaltern, z.B. herkömmliche elektromechanische Schalter, kann gekappt werden. Stattdessen wird die Schalteinheit der Sicherheitseinrichtung angeschlossen. Bei Aufzügen kann somit der Aufwand zum Nachrüsten erheblich reduziert werden. Es reicht regelmäßig aus, eine längere Verbindungsleitung über die Stockwerke einzuziehen. Beide Leitungen zu den alten Öffnungsschaltern können zudem meist unkompliziert praktisch an einer einem Ort in der Nähe der Steuerzentrale gekappt werden.

Im Zusammenhang mit dem Nachrüsten wird eine Nachrüstvorrichtung in einer entsprechenden, nachzurüstenden Aufzugvorrichtung eingebaut, wobei die Aufzugvorrichtung einen Sicherheitskreis aufweist, der im Sinne der Erfindung dem ersten Sicherheitskreis entspricht und Öffnungsschalter aufweist. Die Nachrüstvorrichtung umfasst Sensoren, die in Abhängigkeit vom Schließzustand der Aufzugstür zwischen wenigstens zwei Schaltzuständen schaltbar sind. Des Weiteren umfasst die Nachrüstvorrichtung eine Schalteinheit, die anstelle der zu ersetzenden Öffnungsschalter einzusetzen ist. Mittels der Sensoren ist die Schalteinheit schaltbar. Sensoren und Schalteinheit können z,B. über Modulation der Spannung/Stromstärke bzw. des Eigenwiderstandes der Sensoren Informationen austauschen.

### Ausführungsbeispiel:

Ausführungsbeispiele der Erfindung sind in den Zeichnungen dargestellt und werden nachstehend unter Angabe weiterer Einzelheiten und Vorteile näher erläutert.

Im Einzelnen zeigen:
Figur 1 einen Sensor aus Kontaktbrücke mit Reflexionsstreifen und Kontaktiehmer,
Figur 2 ein Kontaktnehmer,
Figur 3 eine Kontaktbrücke mit Reflexionsstreifen,
Figur 4 einen Sensor aus Kontaktbrücke mit Lichtleiter und Kontaktnehmer,
Figur 5 ein Kontaktnehmer, wie in Figur 2,
Figur 6 eine Kontaktbrücke mit Lichtleiter,
Figur 7 das Verbinden (zeitlicher Ablauf) von Kontaktbrücke und Kontaktnehmer,
Figur 8 einen Sensor mit Reflexicnsstreifen,
Figur 9 eine Sicherungsvorrichtung mit Sensoren,
Figur 10 eine Sicherungsvorrichtung mit Sicherheitskreis,
Figur 11 eine Sicherungsvorrichtung mit Bus,
Figur 12 eine Sicherungsvorrichtung mit Bus und integriertem Schütz in der Schalteinheit,
Figur 13 ein Schaltplan für einen Aufzug,
Figur 14 einen Sensor mit Lichtleitern,
Figur 15 eine perspektivische Ansicht des Sensors gem. Figur 14, sowie
Figur 16 eine schematische Darztellung, wie in einer Sicherungsvorrichtung gem. der Erfindung die Kommunikation mit einzelnen Sensoren stattfindet.

### Ausführungsbeispiele im Zusammenhang mit einer Sicherungsvorrichtung bei Aufzügen:

Eine beispielhafte Sicherungsvorrichtung für Aufzugvorrichtungen, die über einen Antrieb eine Kabine verfahren können, umfasst: einen ersten Sicherheitskreis, der einen geschlossenen und einen geöffneten Leitungszustand aufweist, mit einer Unterbrechungsvorrichtung zum Unterbrechen des Antriebs in Abhängigkeit vom Leitungszustand des ersten Sicherheitskreises, und einer zusätzlichen Sicherheitseinrichtung, die wenigstens zwei Sensoren umfasst, welche in Abhängigkeit vom Schließzustand der Aufzugstür zwischen wenigstens zwei Schaltzuständen schaltbar sind, wobei eine Schalteinheit vorhanden ist, die durch Verbindung mit der Sicherheitseinrichtung zwischen wenigstens zwei Schaltzuständen schaltbar ist. Ferner ist die Schalteinheit dazu ausgebildet, den geschlossenen und/oder geöffneten Leitungszustand des ersten Sicherheitskreises zu bewirken. Die zusätzliche Sicherungseinrichtung entspricht somit einer Schaltungseinrichtung gemäß der Erfindung. Die Unterbrechungsvorrichtung dient zum Unterbrechen des Antriebs, wobei die Unterbrechung davon abhängt, wie die Schaltzustände der Schalteinheit und darüber hinaus sonstiger Schalter im ersten Sicherheitskreis sind, dass heißt davon, ob tatsächlich alle Türen verriegelt sind. Durch diese Maßnahme kann entsprechend die Wartungsanfälligkeit verbessert und die Sicherheit des Aufzugs erhöht werden.

Sind mehrere Türen vorhanden, so kann die Fahrt nur begonnen oder fortgesetzt werden, wenn alle Türen verriegelt sind. Dementsprechend ist es zweckmäßig, wenn die entsprechenden Sensoren, welche jeweils einer Tür zugeordnet sind, in Serie geschaltet sind.

Der erste Sicherheitskreis weist beispielsweise Öffnungeschalter und ein Relais / Schütz als Unterbrechungsvorrichtung auf. Die Öffnungsschalter können bei herkömmlichen Sicherheitskreisen als elektromechanische Schalter ausgebildet sein. Wird ein geöffneter Leitungszustand bewirkt, also der erste Sicherheitskreis unterbrochen, so öffnet auch das Relais bzw. das Schütz und unterbricht zum Beispiel einen Motor des Aufzugs.

Die Sicherheitseinrichtung kann gewissermaßen als Ersatzschaltung für einzelne Öffnungsschalter oder für alle Öffnungsschalter angesehen werden, die den Schließzustand bzw. Verriegelungszustand der Tür überwachen. Grundsätzlich kann es sich bei der Sicherheitseinrichtung auch um einen zweiten Sicherheitskreis handeln.

Die Sicherheitsseinrichtung kann als zweiter Sicherheitskreis ausgebildet sein, der wenigstens zwei Sensoren umfasst, welche in Abhängigkeit vom Schließzustand der Aufzugstür zwischen wenigstens zwei Schaltzuständen schaltbar sind. Die Unterbrechungsvorrichtung kann jedoch dazu ausgebildet sein, unter anderem in Abhängigkeit vom Schaltzustand einer Schalteinheit (nicht des Sensors unmittelbar) den Antrieb zu unterbrechen und/oder fortzusetzen. Die Schalteinheit wiederum ist durch Verbindung mit dem Sicherheitskreis zwischen wenigstens zwei Schaltzuständen schaltbar. Somit sind die Unterbrechungsvorrichtung und das Schalten der Unterbrechungsvorrichtung zwar vom Sicherheitskreis abhängig, jedoch nicht direkt an diesen gekoppelt, sondern indirekt über eine zwischengeschaltete Schalteinheit. Diese Vorrichtung ermöglicht gewissermaßen, dass der Sicherheitskreis bzw. die Anordnung von Sensoren als eine separate Vorrichtung "entkoppelt" wird. Dies kann insbesondere dann vorteilhaft sein, wenn für die Unterbrechungsvorrichtung eine Vorrichtung mit vergleichsweise hohen Spannungen benötigt wird. Eine derartige Vorrichtung bietet entsprechende Nachteile bei der Montage bzw. bei der Wartung, da gegebenenfalls spannungsführende Teile mit relativ hoher Spannung berührt werden könnten; bei der Sicherungsvorrichtung können diese Nachteile vermieden werden. Der Sicherheitskreis selbst kann allerdings grundsätzlich mit relativ niedrigen Spannungen betrieben werden.

Ferner können die Sensoren wiederum in Serie geschaltet werden. Insbesondere dann, wenn eine derartige Entkopplung erfolgt ist, ist es vorteilhaft gegebenenfalls einen Störzustand eines Sensors zu erkennen. Bei einer gewöhnlichen Serienschaltung jedoch kann grundsätzlich nicht wahrgenommen werden, welcher Sensor möglicherweise durch einen Defekt unterbrochen ist. Bei einer großen Anzahl von Sensoren erfordert dies bei einer Wartung einen entsprechenden Zeit- und somit auch einen entsprechenden Kostenaufwand. Dem kann dadurch entgegnet werden, dass eine Anzeigevorrichtung zur Anzeige des Schaltzustandes der einzelnen Sensoren mit Zuordnung der einzelnen Schaltzustände zu den entsprechenden Sensoren vorgesehen ist. Grundsätzlich ist eine entsprechende Anzeigevorrichtung im Stande, anzuzeigen, welche der Sensor welchen Schaltzustand gerade aufweist bzw. welcher Sensor einen bestimmten Schaltzustand gerade nicht aufweist, beispielsweise welcher Sensor geöffnet ist.

Insbesondere kann die Sicherheitseinrichtung auch als Bussystem ausgebildet sind, wobei die Sensoren jeweils eine Elektronikeinheit aufweisen. Ferner ist der Sensor über seine entsprechende Elektronikeinheit an den Bus angeschlossen. Ein derartiger Bus ermöglicht insbesondere die Übertragung und/oder den Austausch von Daten. Beispielsweise können so auf Befehl Daten einzelner Sensor ausgelesen werden. Denkbar ist grundsätzlich ein bidirektional arbeitender Bus, bei dem Daten gesendet und empfangen werden können. Grundsätzlich ist allerdings auch ein undirektionaler Bus denkbar. Als Daten ist es möglich, die Schaltzustände zu übermitteln, es können aber auch Identifizierungsdaten der Sensor übertragen werden, welche Auskunft darüber geben, um welchen Sensor es sich gerade handelt. Diese Identifizierungsdaten können beispielsweise auch Adressierungen der einzelnen Sensoren sein. Hierdurch wird auf eine besonders elegante Art und Weise ermöglicht, auszulesen, welcher Sensor gerade einen bestimmten Zustand anzeigt. Ferner können Bussysteme gegebenenfalls auch besonders schnell arbeiten.

Zudem kann wenigstens einer der Sensoren wie folgt aufgebaut sein: Ein Sensor für Sicherungsvorrichtungen für Aufzugvorrichtungen, die über einen Antrieb eine Kabine verfahren können, wobei der Sensor als optischer Sensor ausgebildet ist, der einen Sender zum Senden eines optischen Signals und einen Empfänger zum Empfangen des optischen Signals umfasst. Besonders vorteilhaft ist an dem Sensor, dass dieser berührungslos, dass heißt auch verschleißfrei arbeiten kann. Zudem weist der Sensor somit keine oder weniger spannungsführende Kontaktflächen auf und ist darüber hinaus montagesicher. Der Sensor kann deshalb einen handelsüblichen Schalter, einen sog. Interlook switch, aus dem Stand der Technik ersetzen. Zudem ermöglicht der Sensor, dass im Gegensatz zu einem elektromechanischen Schalter keine Unterbrechung des Stromkreises erfolgen muss.

Durch den Sensor kann auch ein Defekt vermieden werden, der z.B. bei elektromechanischen Sensoren und Kontakten durch Kontaktbrand infolge von Funkenüberschlag beim Öffnen bzw. Schließen der elektrischen Kontakte erfolgen und schließlich zum Funktionsverlust führen kann.

Dadurch, dass bei dem Sensor der Stromkreis im Gegensatz zu einem Schalter nicht unterbrochen werden muss, ist in vorteilhafter Weise eine verbesserte Diagnose bei Defekten möglich.

Zudem sind eine Kontaktbrücke und ein Kontaktnehmer zur Aufnahme der Kontaktbrücke vorgesehen, welche so angeordnet sind, dass der Schließzustand der Aufzugstür durch Verbindung von Kontaktnehmer und Kontaktbrücke bestimmbar ist. Der Detektionszustand des Sensors hängt daher von der Annäherung der Kontaktbrücke an den Kontaktnehmer ab.

Ein Aufzug selbst besitzt im Allgemeinen zum einen eine Kabine, welche zwischen einzelnen Stockwerken bzw. Etagen verfahren werden kann. Die einzelnen Etagen besitzen jeweils Schachtöffnungen, in deren Bereich die Kabine in eine Halteposition gefahren werden kann, wenn diese die entsprechende Etage anfahren soll. In dieser Halteposition wird dann ein Zugang zur Kabine ermöglicht. Dieser Zugang kann dadurch ermöglicht werden, dass die Aufzugtüren geöffnet und dann vor der Weiterfahrt wieder geschlossen und verriegelt werden. Aufzugtüren können Schachttüren oder Kabinentüren sein. Die Schachttüren sind im Bereich der Schachtöffnung am Schacht selbst befestigt bzw. verfahrbar gelagert. Die Kabinentüren wiederum sind an der Kabine befestigt und fahrbar gelagert. Regelmäßig ist einer Schachttür jeweils eine Kabinentür zugeordnete wobei beide in Halteposition überlappend (zumindest teilweise überlappend) angeordnet sind. Regelmäßig werden diese auch zumindest im Wesentlichen synchron verfahren.

Damit eine Fahrt in der Kabine aufgenommen werden kann bzw. die Kabine weiter in Fahrt bleiben kann, ist es notwenig, dass sämtliche Türen verschlossen und verriegelt sind. Dies kann über entsprechende Sicherungsvorrichtungen überprüft werden, welche mittels einer Unterbrechervorrichtung gegebenenfalls den Antrieb stoppen kann. Grundsätzlich kann die Unterbrechungsvorrichtung bzw. Unterbrechungskreis die Kontrolleinheit, d. h. Steuerung bzw. Regelung, des Motors bzw. des Antriebs ansprechen, sodass diese den Antrieb stoppt, denkbar ist auch dass die Unterbrechungsvorrichtung direkt die Stromversorgung des Antriebs / Motors unterbricht.

Der entsprechende Sensor ist somit dafür ausgebildet, zu überprüfen, ob die entsprechende Tür eines Aufzugs bzw. eines Schachts offen oder geschlossen und verriegelt ist. Vorliegend ist es besonders vorteilhaft, den Sensor ähnlich einer Steckverbindung auszubilden, sodass eine Kontaktbrücke in einen Kontaktschacht eingreifen kann. Zudem ermöglicht diese Maßnahme eine mechanisch sehr stabile Vorrichtung. Grundsätzlich kann der Sensor so ausgebildet sein, dass die Kontaktbrücke mit Spiel oder formschlüssig in den Schacht des Kontaktnehmers aufgenommen wird.

Ferner ist die Kontaktbrücke so ausgebildet, dass sie wenigstens ein Übertragungselement zur Übertragung eines optischen Signals umfasst. Hierdurch kann insbesondere in vorteilhafter Weise eine sogenannte Fail-safe-Schaltung, also eine ausfallsichere Schaltung erreicht werden. Lediglich dann, wenn die Kontaktbrücke durch entsprechende Verbindung mit dem Kontaktnehmer beim Schließen der Tür eine spezielle Position erreicht hat, kann eine entsprechende Freigabe für die Fahrt erteilt werden. Bei einer bloßen Lichtschranke wäre dies grundsätzlich nicht der Fall: Das Übertragungselement kann nämlich so ausgebildet sein, dass die Übertragung des optischen Signals auf eine spezielle Art und Weise erfolgt, die nur sehr schwer manipuliert werden kann und auch nicht zufällig ohne weiteres realisiert wird. Würde es sich beispielsweise um eine bloße Lichtschranke handeln, welche beim Schließen der Tür unterbrochen würde, so würde dies bedeuten, dass der Antrieb auch dann freigegeben würde, wenn z. B. ein entsprechender Gegenstand, eine Fliege oder Ähnliches die Lichtschranke unterbricht.

Es bietet sich außerdem an, den Sender bzw. den Empfänger am Kontaktnehmer anzuordnen. Die Übertragung des Lichts über das Übertragungselement kann dann lediglich über die Kontaktbrücke erfolgen. Durch diese Ausbildung wird eine besonders kompakte Bauweise ermöglicht.

Eine Möglichkeit besteht darin, das Übertragungselement als Reflexionsfläche auszubilden, wobei diese dann das optische Signal bzw. das Licht reflektiert und nur so auf den entsprechenden Empfänger leitet. Die Reflexionsfläche kann zum Beispiel in einer Kerbe in der Kontaktbrücke angeordnet sein. Denkbar ist jedoch ferner, dass es sich bei dem Übertragungselement um ein optisches Medium handelt. Denkbar ist beispielsweise, dass die Lichtbrechung beim Übergang von der Luft in dieses optische Medium ausgenutzt wird und der Lichtstrahl somit in eine gewisse Richtung gelenkt wird, sodass nur dann entweder auf dem Empfänger oder gerade nicht auf den Empfänger geleitet wird.

Als optisches Medium kann ferner ein Lichtleiter vorgesehen sein. Das optische Signal wird dann übertragen, wenn dessen Licht in den Lichtleiter eingekoppelt wird, durch den Lichtleiter propagiert und über den Lichtleiter in den Empfänger gelangt.

Besonders vorteilhaft ist es, den Sender als Leuchtdiode und/oder dem Empfänger als Photodiode auszubilden. Es handelt sich dabei um besonders günstige Standardelektronikbauteile; hierdurch können insbesondere Kosten eingespart werden.

Im Übrigen ist auch denkbar, dass der Kontaktnehmer Übertragungselemente zur Übertragung des optischen Signals umfasst, z.B. Reflexionsflächen oder optische Medien wie z.B. Lichtleiter. Denkbar ist, dass eine Teilstrecke des Propagationsweges des optischen Signals vom Sender zum Empfänger über eine Reflexionsfläche bzw. durch einen Lichtleiter im Kontaktnehmer erfolgt. Denkbar ist auch, dass durch Aufnahme der Kontaktbrücke der Lichtleiter im Kontaktnehmer oder in der Kontaktbrücke so verschoben wird, dass eine Übertragung des Lichts ermöglicht wird.

Des Weiteren kann der Sensor eine Elektronikeinheit zur Auswertung des Empfängers umfassen, welche dazu ausgebildet ist, die Auswertung des Empfängers in einem der Schaltzustände und/oder in ein elektrisches Signal zu interpretieren. Dies bedeutet, dass die Elektronikeinheit dazu ausgebildet ist, ein elektrisches Signal zu erzeugen oder einen elektrischen Kontakt herzustellen. Da jedoch der mechanische Schließzustand auf rein optischem Wege detektiert wird, bedeutet dies, dass nicht zwingend wieder eine Herstellung eines mechanischen Kontaktes oder eines mechanischen Öffnungszustandes notwendig ist, um ein elektrisches Signal zu erhalten. Denkbar ist beispielsweise, dass das optische Signal den Empfänger, beispielsweise eine Photodiode, durchschaltet und somit ein Leitungszustand (im Gegensatz zu einer Unterbrechung) erreicht werden kann. Hierdurch wird gewissermaßen elektronisch eine Interpretation des Schaltzustandes des Sensors durchgeführt. Die Elektronikeinheit kann allerdings auch zusätzlich dazu ausgebildet sein, eine Anbindung an weitere Elektronik zu ermöglichen. Beispielsweise kann sie auch dazu ausgebildet sein, eine Anbindung an einen Bus zu ermöglichen. Durch diese Ausbildung kann insbesondere noch einmal die geringere Wartungsanfälligkeit verbessert werden, da mechanische Kontakte und Sensor im Wesentlichen vermieden werden. Besonders vorteilhaft ist auch, dass als mechanischer Kontaktschluss lediglich das Eindringen der Kontaktbrücke in den Kontaktnehmer notwendig ist.

Damit kein Streulicht zufällig vom Sender in den Empfänger gelangt, kann zusätzlich ein Trennsteg zur optischen Trennung von Sender und Empfänger vorgesehen sein. Dies verringert noch einmal grundsätzlich die Möglichkeit, dass Fehler aufgrund einer falschen Interpretation der Signale auftreten. Zusätzlich kann im Übrigen auch ein Diffusor vorgesehen sein, welcher Streulicht diffus verbreitet. Denkbar ist ferner, dass der Empfänger bei der Detektion auf einen gewissen Schwellwert hinsichtlich der Intensität des einfallenden Lichtes eingestellt wird, sodass bei einer gewissen Menge von Streulicht, die gegebenenfalls in den Empfänger hineinfällt, nicht dennoch ein entsprechendes Folgesignal ausgelöst wird, welches lediglich dann aufgelöst werden sollte, wenn Über das Übertragungselement Licht in dem Empfänger fällt.

Besonders robust kann beispielsweise eine Verbindung hergestellt werden, bei der der Kontaktnehmer einen Schacht und die Kontaktbrücke eine zungenförmige Lasche umfasst, welche bei Verbindung von Kontaktbrücke und Kontaktnehmer in den Schacht eingreift. Besonders vorteilhaft ist dabei auch, dass eine entsprechende Codierung vorgenommen werden kann, dass heißt, dass die Kontaktbrücke, ähnlich wie ein Schlüssel, besonders ausgebildet sein muss, damit sie in den Kontaktnehmer eindringen kann. Dies kann insbesondere die Sicherheit dieser Vorrichtung erhöhen, insbesondere dann, wenn der Kontaktnehmerschacht so ausgebildet ist, dass keine Hand eindringen kann.

Es können ebenfalls bei einem entsprechenden Sensor wenigstens zwei Übertragungselemente vorgesehen sein, welche in Bewegungsrichtung der Kontaktbrücke hintereinander angeordnet sind, das bedeutet, dass beim Verriegeln der Tür die Kontaktbrücke entsprechend in den Kontaktnehmer eintaucht und zunächst für das optische Signal bzw. den optischen Lichtstrahl eines der Übertragungselemente (nämlich das erste in Bewegungsrichtung) sichtbar wird. Beim Weiterschieben wird anschließend das nächste Übertragungselement sichtbar, während das vorangegangene aus dem optischen Weg heraus geschoben wird. Es können somit zeitlich versetzt mehrere optische Signale auftreten. Ferner ist es denkbar, die Elektronikeinheit so auszubilden oder die entsprechenden Signale an eine weitere Auswerteeinheit weiter zu leiten, sodass beispielsweise das Auftreten der entsprechenden Signale in Abhängigkeit von der Zeit ermittelt wird. Darüber können Rückschlüsse über die Geschwindigkeit der Verriegelung ermittelt werden. Dies ermöglicht auch einen Rückschluss auf den Funktions- und Wartungszustand der Verriegelungseinrichtung der Türe. Grundsätzlich wird im Übrigen die Verriegelung, nicht der Türschluss überwacht. Je nach dem, wie die entsprechenden Übertragungselemente angeordnet sind bzw. wie viele der Übertragungselemente angeordnet sind, kann gegebenenfalls die Präzision einer solchen Bestimmung erhöht werden.

Ebenso kann eine entsprechende Anzeigevorrichtung vorgesehen sein, welche es beispielsweise ermöglicht, zu identifizieren welcher der Sensor gerade einen bestimmten Schaltzustand besitzt und möglicherweise defekt ist.

Des Weiteren kann der Sensor eine Elektronikeinheit zur Auswertung des Empfängers umfassen, welche dazu ausgebildet ist, die Auswertung des Empfängers in einem der Schaltzustände und/oder in ein elektrisches Signal zu interpretieren. Dies bedeutet, dass die Elektronikeinheit dazu ausgebildet ist, ein elektrisches Signal zu erzeugen oder einen elektrischen Kontakt herzustellen. Da jedoch der mechanische Schließzustand auf rein optischem Wege detektiert wird, bedeutet dies, dass nicht zwingend wieder eine Herstellung eines mechanischen Kontaktes oder eines mechanischen Öffnungszustandes notwendig ist, um ein elektrisches Signal zu erhalten. Denkbar ist beispielsweise, dass das optische Signal den Empfänger, beispielsweise eine Photodiode, durchschaltet und somit ein Leitungszustand (im Gegensatz zu einer Unterbrechung) erreicht werden kann. Hierdurch wird gewissermaßen elektronisch eine Interpretation des Schaltzustandes des Sensors durchgeführt. Die Elektronikeinheit kann allerdings auch zusätzlich dazu ausgebildet sein, eine Anbindung an weitere Elektronik zu ermöglichen. Beispielsweise kann sie auch dazu ausgebildet sein, eine Anbindung an einen Bus zu ermöglichen. Durch diese Ausbildung kann insbesondere noch einmal die geringere wartungsanfälligkeit verbessert werden, da mechanische Kontakte und Sensor im Wesentlichen vermieden werden. Besonders vorteilhaft ist auch, dass als mechanischer Kontaktschluss lediglich das Eindringen der Kontaktbrücke in den Kontaktnehmer notwendig ist.

Die Elektronikeinheit bzw. Kommunikationseinheit ist zur Kommunikation mit einer Schalteinheit, insbesondere zur Übermittlung von Schaltzuständen und/oder Identifikationssignalen. Die Schalteinheit ist ein Bauteil, mit dem durch einen Schaltvorgang ein Leitung geöffnet oder geschlossen werden kann, ähnlich wie bei einem Relais bzw. Schütz. Der Schaltvorgang wird jedoch dann ausgelöst, wenn von den Sensoren ein entsprechendes Signal bzw. eine entsprechende Information an den die Schalteinheit weitergegeben wird. Vorteilhaft ist insbesondere, dass die Leitung zwischen Schalteinheit und Sensor nicht mehr unterbrochen werden muss, wie es zum Beispiel regelmäßig bei einem Schütz / Relais der Fall ist.

Die Elektronikeinheit kann insbesondere Kontaktnehmer angeordnet sein, in dem auch Sender und Empfänger angeordnet sind. Der Kontaktnehmer kann in der Aufzugvorrichtung z.B. statisch angeordnet sein, während die Kontaktbrücke an einem beweglichen Teil angeordnet ist und lediglich den "Schlüssel" darstellt, um die Signalübertragung in dem Kontaktnehmer zu ermöglichen.

Ein Sensor kann genau zwei Anschlüsse umfassen, die zum einen der Stromversorgung und zum anderen der Kommunikation mit der Elektronikeinheit dienen. Zur Kommunikation dient also die gleiche Leitung, die auch zur Stromversorgung verwendet wird. Diese Maßnahme ermöglicht eine besonders kompakte und kostengünstige Bauweise. Zudem wird ermöglicht, dass bei einer Nachrüstung, wenn z.B. ein herkömmlicher Sensor durch einen Sensor gemäß der Erfindung ausgetauscht wird, keine zusätzlichen Leitungen bzw. Anschlüsse verlegt werden müssen.

Ferner kann bei einem Sensor die Kommunikation über eine Modulation seines Eigenwiderstandes des Sensors erfolgen. Im Stromkreis mit der Schalteinheit kann dadurch je nach Schaltung die Spannung und/oder der Stromstärke moduliert werden. Diese Modulation trägt dann die Information, die bei der Kommunikation übertragen werden soll. Denkbar ist z.B. ein Stromkreis, der in Reihe geschaltete Sensoren und (ebenfalls in Reihe geschaltet) eine Schalteinheit umfasst. Wird der Widerstand eines Sensors bei in Reihe geschalteten Sensoren verändert, so ändert sich die Stromstärke. Wir z.B. eine Konstantstromquelle für den Stromkreis verwendet, so bewirkt eine Änderung des Widerstandes, dass die Spannung erhöht werden muss, um die sich ergebende Abnahme der Stromstärke, die durch den geringeren Widerstand zunächst verursacht wird, auszugleichen. Die Modulation kann also Träger der Information sein. Die Änderungen von Stromstärke bzw. Spannung sind messbar und können als Information interpretiert werden.

Die Schalteinheit wiederum ist bei einer Weiterbildung der Erfindung dazu ausgebildet, die Kommunikation mit den Sensoren durch Modulation der Stromstärke bzw. der Spannung durchzuführen. Diese Maßnahme kann durch Änderungen von Widerständen oder entsprechenden Änderungen bzw. Anpassungen von Spannung oder Stromstärke erfolgen.

Bei einer Reihenschaltung ist es insbesondere vorteilhaft, wenn der Sensor einen niedrigen Durchgangswiderstand aufweist. Der Widerstand eines Sensors kann beispielsweise im Bereich von größer als 0 Ohm bis 100 Ohm, insbesondere im Bereich von größer als Ohm bis 20 Ohm, vorzugsweise kleiner als 5 Ohm liegen. Gerade bei einer Reihenschaltung ist es vorteilhaft, den Durchgangswiderstand möglichst klein, vorzugsweise kleiner als 10 Ohm, insbesondere kleiner als 5 Ohm auszulegen, damit keine zu hohe Spannung über dem Sensor abfällt.

Denkbar ist insbesondere, dass die Kontaktbrücke an einer Aufzugstür und der Kontaktnehmer an der Kabine selbst angebracht sind. Grundsätzlich ist allerdings auch ein umgekehrter Aufbau, nämlich der Kontaktnehmer an der Aufzugstür und die Kontaktbrücke an der Kabine, denkbar. In analoger Weise können Kontaktbrücke und Kontaktnehmer auch an der Schachttür und am Schacht bzw. der Schachtzarge angeordnet sein.

Der Kontaktnehmer selbst kann des weiteren ein Gehäuse mit Montageelementen und den bereits geschilderten Einführschlitz für die Kontaktbrücke aufweisen. Die Elektronikeinheit kann als Lichtleiterplatte (englische Abkürzung: PCB) mit einer Leuchtdiode (englische Abkürzung: LED) sowie einer entsprechenden Photodiode als Empfänger ausgestattet sein. Der Trennsteg kann entsprechend zwischen Sender und Empfänger angeordnet werden. Ferner ist auch denkbar, dass entsprechende Kontakte, beispielsweise zur Kontaktierung mit der Fotodiode einen Anschluss an einer entsprechenden Elektronikeinheit ermöglichen. Die Elektronikeinheit kann auch als separates Bauteil oder integriert in einen sonstigen Teil des Aufzugs vorgesehen sein. Grundsätzlich kann der Lichtschluss zwischen Sender und Empfänger gewissermaßen in ein elektrisches Signal umgewandelt werden. Die Kontaktbrücke kann wiederum eine Montageplatte aufweisen, eine entsprechende Zunge mit Lichtleitfasern, wobei in diesem Fall die entsprechenden Lichtleitfasern bei eingefahrener Zunge Licht von der LED zur Photodiode führen können. Gegebenenfalls können die entsprechenden Teile insbesondere auch vormontiert werde.

Besonders vorteilhaft ist, dass fast keine spannungsführenden Kontaktflächen vorgesehen sind, die Montage also sehr sicher erfolgen kann. Die Auswertung der Geschwindigkeit des Beleuchtungsanstiegs an der Photodiode oder der Abfolge der Lichtimpulse zweier Licht-Übertragungselemente erlaubt im Hinblick auf den Wartungszustand den Rückschluss auf die Geschwindigkeit der Verriegelung der Tür. Somit können ferner Informationen über den Wartungszustand bzw. die Alterung der Vorrichtung ermittelt werden. Ferner kann eine Auswertung der endgültigen Beleuchtungsstärke im Zusammenhang mit der zeitlichen Entwicklung der Beleuchtung erfolgen. Dies kann insbesondere einen Rückschluss auf die Eintauchtiefe sowie ferner auf die Verriegelungssicherheit erlauben. Mehrere Übertragungselemente ermöglichen ferner eine dynamische Detektion. Zudem ist es denkbar, die Robustheit dadurch zu erhöhen, dass konstruktive Maßnahmen vorgesehen werden, die das Verdecken der LED bzw. der Photodiode vorsehen. Gerade durch die Ausbildung eines Kontaktnehmers in Form eines Schachtes wird dies besonders vorteilhaft ermöglicht.

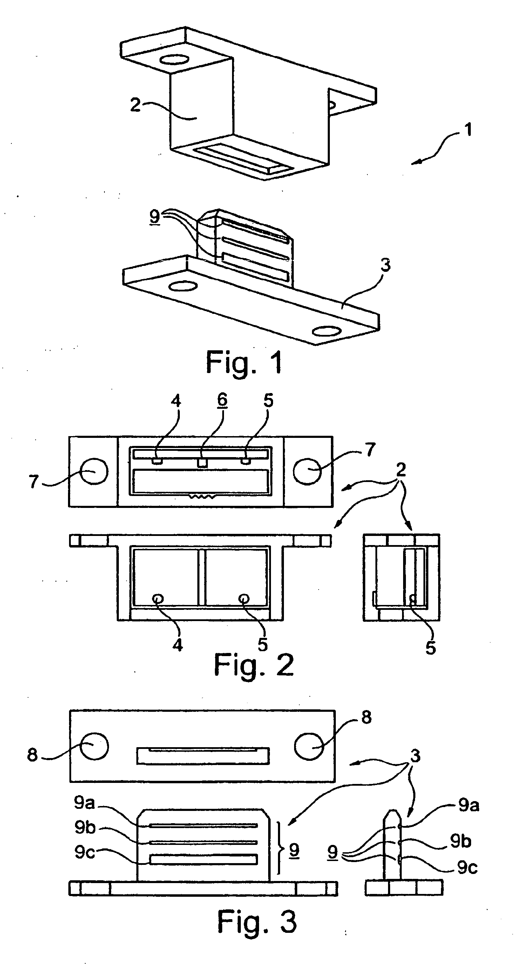

Figur 1 zeigt einen Sensor 1 mit einem Kontaktnehmer 2 (Schacht) und einer Kontaktbrücke 3, wobei die Kontaktbrücke Reflexionsstreifen 9 aufweist, die von einem Sender des Kontaktnehmers 2 ausgestrahltes Licht in Richtung eines Empfängers des Kontaktnehmers 2 reflektieren.
Figur 2 zeigt wiederum den entsprechenden Kontaktnehmer 2 mit einem Sender 4 und einem Empfänger 5, zwischen denen ein Trennsteg 6 angeordnet ist, und zwar in Vorderansicht, Seitenansicht und Draufsicht. Mit dem Bezugszeichen 7 sind Montagevorrichtungen bzw. Montagehilfen angegeben. Der Kontaktnehmer 2 weist zusätzliche elektrische Anschlüsse auf, über welche der Sensor 1 mit der restlichen Sensorvorrichtung bzw. mit dem Sicherheitskreis verbunden werden kann.
Figur 3 zeigt eine Kontaktbrücke in verschiedenen Ansichten und zwar in Vorderansicht, Seitenansicht und Draufsicht. Auch diese umfasst entsprechende Montagehilfen 8. Als Übertragungselemente 9 sind Schlitze in die Kontaktbrücke 3 eingearbeitet, die jeweils Reflexionsflächen aufweisen. Insgesamt gibt es drei Reflexionseinheiten 9a, 9b, 9c, sodass gewissermaßen eine dynamische Kontaktdetektion ermöglicht wird, da beim Eindringen der Kontaktbrücke 3 in den Kontaktnehmer 2 bzw. in den optischen Lichtweg zunächst die Reflexionseinheit 9a, danach die Reflexionseinheit 9b und schließlich 9c eindringen und somit eine dynamische Messung des Signals in zeitlicher Abhängigkeit möglich wird.

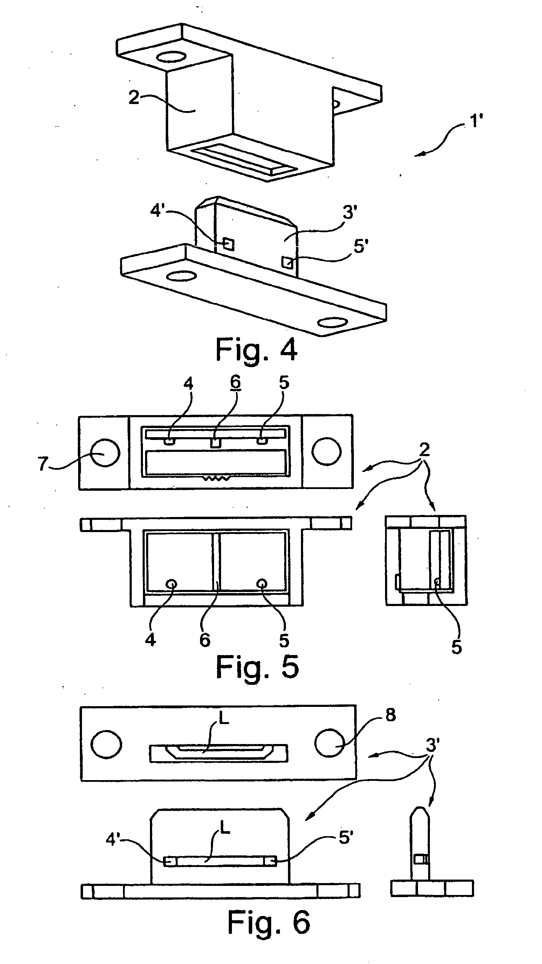

Figur 4 zeigt einen Sensor 1' mit einem Kontaktnehmer 2 (Schacht) und einer Kontaktbrücke 3', wobei die Kontaktbrücke einen Lichtleiter aufweist; das von einem Sender des Kontaktnehmers 2 ausgestrahltes Licht gelangt in den Lichtleitereingang 4', propagiert durch den Lichtleiter und tritt aus dem Lichtleiterausgang 5' wieder aus, sodass es in zum Empfänger des Kontaktnehmers 2 gelangt.
Figur 5 zeigt wiederum den entsprechenden Kontaktnehmer 2, wie er bereits zu Figur 2 beschrieben wurde, der auch für einen Sensor 1' mit Lichtleiter geeignet ist.
Figur 6 zeigt eine Kontaktbrücke 3' in verschiedenen Ansichten, und zwar in Vorderansicht, Seitenansicht und Draufsicht. Auch diese umfasst entsprechende Montagehilfen 8. Als Übertragungselement L ist ein Lichtleiter in die Kontaktbrücke 3' eingearbeitet, durch den das vom Kontaktnehmer ausgesendete Lichtsignal propagierten kann. Zu sehen sind auch der Lichteinlass 4' und der Lichtausgang 5'.

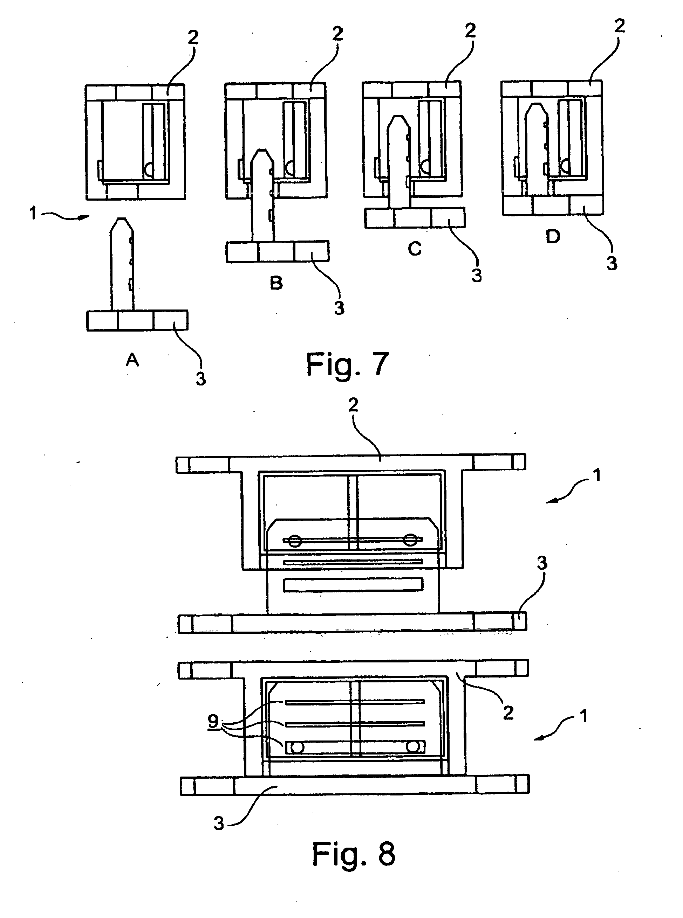

Figur 7 zeigt ein derartiges Eindringen der Kontaktbrücke 3 (mit Reflexionsstreifen) in den Kontaktnehmer 2, wobei in Situation A die Kontaktbrücke noch nicht in Verbindung mit dem Kontaktnehmer 2 steht. In Situation B ist die Reflexionseinheit 9a gerade im Bereich des optischen Weges eingedrungen und überträgt den Lichtweg vom Sender zum Empfänger. In Situation C steht die Kontaktbrücke 3 gerade so, dass eine Unterbrechung des optischen Signals erfolgt, da die Kontaktbrücke 3 in ihrer Höhe gerade zwischen den Reflexionseinheiten 9b und 9c steht und der optische Weg somit unterbrochen ist. Erst in Situation D steht die Kontaktbrücke, welche voll in den Kontaktnehmer 2 eingefahren ist, in einer derartigen Stellung, dass der optische Weg nicht unterbrochen ist und vom Empfänger 4 Licht über das Reflektionselement 9c in den Detektor/die Photodiode gelangen kann. Die Reflexionseinheiten 9, und auch sonstige Übertragungseinheiten wie optische Medien, können verschiedene Formen aufweisen und charakteristische Reflexionen oder Lichtübertragungen bieten, sodass diese jeweils mittels des Empfängers bzw. der Elektronikeinheit auch gegebenenfalls identifiziert werden können.
Figur 8 zeigt eine ähnliche Darstellung, bei der die Kontaktbrücke 3 in den Kontaktnehmer 2 eindringt.

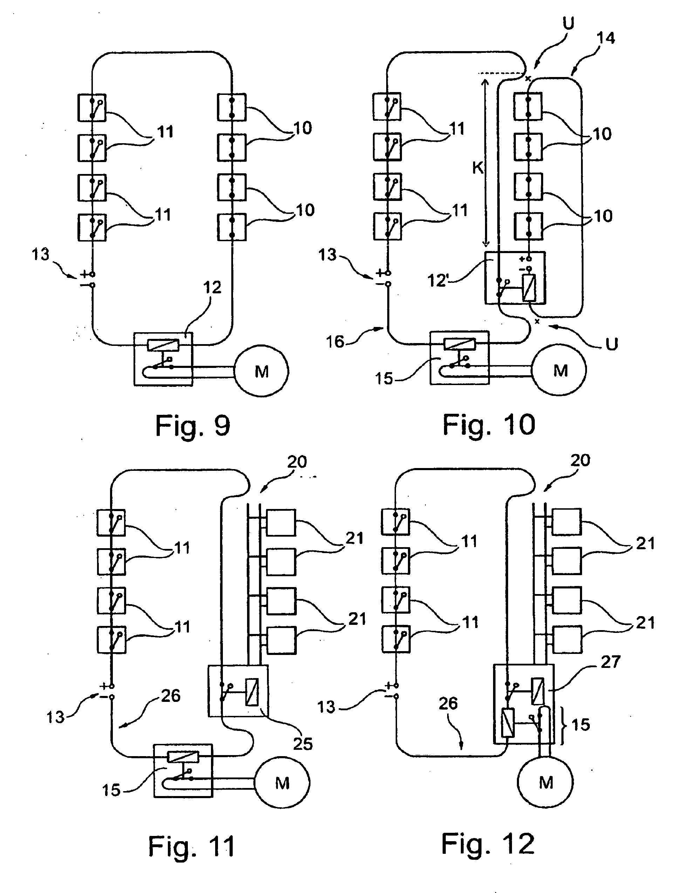

Figur 9 wiederum zeigt eine Sicherungsvorrichtung mit mehreren optischen Sensoren 10, welche alle in Serie geschaltet sind. Des Weiteren sind eine Reihe weiterer elektromechanischer öffnungsschalter 11 vorhanden, welche in sonstiger Weise in Verbindung mit einem Aufzug verwendet werden können. Zudem ist eine Spannungsquelle 13 vorhanden. Alle diese Schalter bzw. Sensoren 11 und 10 sind in Serie geschaltet und mit einer Schalteinheit 12 verbunden. Dieser Stromkreis aus einer Reihenschaltung der Schalter 11, der Sensoren 10 und der Schalteinheit 12 bildet einen Sicherheitskreis. Ist einer der Schalter 11 unterbrochen, so ist der gesamte Stromkreis unterbrochen, und die Schalteinheit 12 schaltet den Motor M, der den Antrieb für die Aufzugskabine darstellt, ab. Die Schalter 11 können Öffnungsschalter bekannter Art sein. Detektiert einer der Sensoren 10, dass z.B. der Aufzug nicht ordnungsgemäß verriegelt ist, so sendet dieser ein entsprechendes Signal über den Schaltkreis, das von der Kommunikationseinheit der Schalteinheit 12 empfangen wird, sodass sie den Motor M abschalten kann. Dementsprechend übernimmt die Schalteinheit 12 teilweise die Funktion deines Relais; zusätzlich sind Schaltvorgänge der Schalteinheit aber auch abhängig von Signalen der Sensoren. Die Schalteinheit 12 reagiert also nicht nur auf Leitungsunterbrechungen,
Figur 10 zeigt eine Sicherungsvorrichtung mit einer Sicherheitseinrichtung, nämlich einem (zweiten) Sicherheitskreis 14, mit entsprechenden optischen Sensoren 10. Dieser Sicherheitskreis ist über eine Schalteinheit 12' mit dem ersten Sicherheitskreis 16 verbunden, der wiederum weitere Sensor 11 aufweist. Die Schalteinheit 12' ist ähnlich zu der Schalteinheit 12 und besitzt die gleiche Funktionsweise; vorliegend ist im Gegensatz zur Schalteinheit 12 aus Figur 9 jedoch die Spannungsquelle mit in der Schalteinheit 12' integriert. Im ersten Sicherheitskreis 16 befindet sich ein Schütz / Relais 15, welches wiederum einen Antrieb M ausschalten kann. Das Schütz 15 ist lediglich dazu ausgebildet, im Falle einer Leitungsunterbrechung des Kreises 16 den Motor M abzuschalten. Ist einer der Sensoren 10 optisch unterbrochen, so wird auch die Schalteinheit 12' unterbrochen und somit die Leitung des ersten Sicherheitskreises 16. Das Schütz 15 schaltet den Motor M ab. Anstelle der üblichen Öffnungsschalter sind die erfindungsgemäßen Sensoren in einem eigenen Sicherheitskreis 14 zusammengefasst und über die Schalteinheit 12' mit dem ursprünglichen, ersten Sicherheitskreis 16 verbunden. Der Sicherheitskreis 16 kann dabei zum Teil die Verkabelung der ursprünglichen Sicharungsvorrichtung verwenden.
   In Figur 10 ist zudem dargestellt, wie eine Nachrüstung einer herkömmlichen Vorrichtung erfolgen kann, indem der ursprüngliche erste Sicherheitskreis 16 an den Stellen U gekappt wird und der zweite Sicherheitskreis 14 mit der Schalteinheit 12' entsprechend eingesetzt wird. Es muss dann nur ein längeres Kabel K eingezogen werden.
Figur 11 zeigt eine entsprechende Vorrichtung bei der statt eines zweiten Sicherheitskreises als Sicherungseinrichtung ein Bus 20 angeordnet ist. Die entsprechenden Sensor 21 weisen eine Elektronikeinheit auf, welche eine Verbindung zu dem entsprechenden Bus 20 ermöglichen. Der Bus ist ebenfalls an eine Schalteinheit 25 angeschlossen, sodass bei Unterbrechen eines der optischen Sensor 21 dieser wiederum ein Signal an die Schalteinheit 25 sendet, welche den ersten Sicherheitskreis 26 wiederum unterbricht. Mit dem Schütz 15 wird aufgrund der unterbrochenen Leitung des Sicherheitskreises 26 der Motor M abgeschaltet. Die Schalteinheit 25 kann z.B. den Master im Bus bilden, während die Sensoren 21 in Slave-Konfiguration vorliegen.
Figur 12 zeigt eine ähnliche Vorrichtung wie Figur 8, jedoch ist hier der Schütz 15 in die Schalteinheit 27 zusätzlich integriert, wobei das Schütz den Motor gegebenenfalls abschaltet.

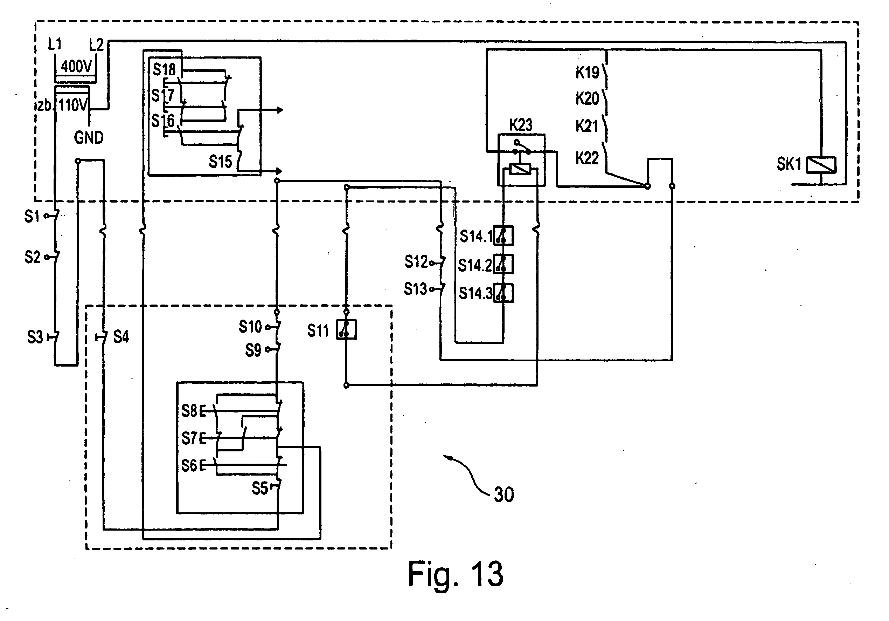

Figur 13 zeigt einen exemplarischen Schaltplan 30 für einen Aufzug gem. der Erfindung.

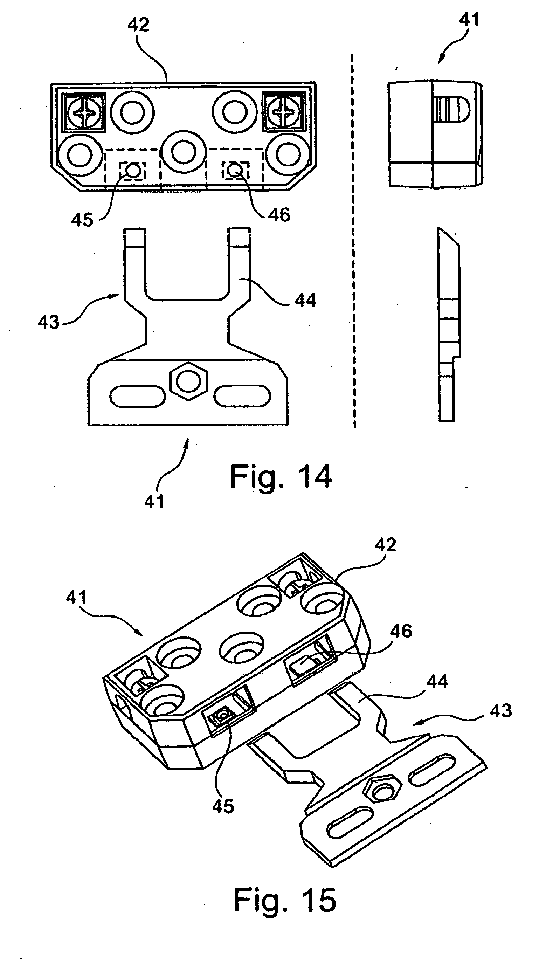

Figur 14 zeigt einen Sensor 41 in Draufsicht und in einer Seitenansicht mit einem Kontaktnehmer 42 und einer Kontaktbrücke 43, in welcher ein Lichtleiter 44 angeordnet ist. Vorliegend ist die Kontaktbrücke 43 insgesamt als Lichtleiter 44 ausgebildet, besteht also aus dem entsprechenden optischen Medium. Der Kontaktnehmer 42 umfasst einen Sender 45 und einen Empfänger 46 zum Senden / Empfangen von optischen Signalen. Das vom Sender 45 ausgesandte optische Signal kann, sobald der Kontaktnehmer 42 die Kontaktbrücke 43 aufgenommen hat, durch den Lichtleiter 44 propagieren und gelangt so in den Empfänger 46. Die Kontaktbrücke 43 (bzw. der Lichtleiter 44) ist U-förmig ausgebildet und greift, wenn sie in den Kontaktnehmer 42 gesteckt wird, lediglich mit den beiden Schenkeln in die beiden Schächte des Kontaktnehmers 42 ein. Der Lichtleiter 44 ist dementsprechend ebenfalls U-förmig ausgebildet. Figur 15 wiederum zeigt den Sensor 41 in einer perspektivischen Ansicht.

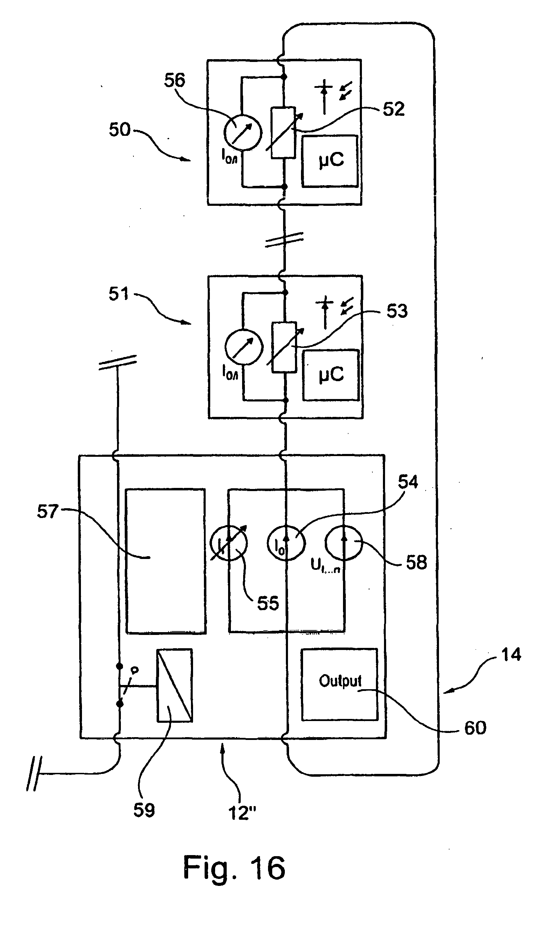

Figur 16 zeigt eine schematische Darstellung der Kommunikation im Sicherheitskreis 14 zwischen dem Controller 57 der Schalteinheit und den einzelnen Sensoren 10 bzw. deren Mikrocontrollern µC dar. Die Kommunikation vom Controller 57 zu den einzelnen Sensoren erfolgt über eine Strommodulation, während umgekehrt vom Sensor 10 zum Controller 57 eine Spannungsmodulation erfolgt.

Regelmäßig ist es erforderlich, dass deutliche Strom- bzw. Spannungsänderungen bzw. -modulationen erfolgen, da wegen der in Aufzugsystem vorkommenden großen Kabellängen die Änderung sonst unmerklich wäre. Zum Beispiel sind Stromänderungen im Bereich von Faktor 3 denkbar.

Die Einheiten 50, 51 entsprechen jeweils einem Sensor. Mit den Bezugszeichen 52, 53 sind veränderbare Widerstände dargestellt. Jedem Sensor ist ein veränderbarer Widerstand zugeordnet. Die Veränderung des Widerstandes kann auf verschiedene Art und Weise erfolgen: Denkbar ist, dass parallel Widerstände zu anderen hinzugeschaltet werden, wodurch sich der Gesamtwiderstand entsprechend verringert. Es ist aber auch denkbar, dass schaltungstechnisch, etwa durch Sperren einzelner Transistoren, der Widerstand beeinflusst wird. Die Veränderung des Widerstandes kann optisch beeinflusst werden, z.B. durch Phototransistoren, Photodioden, Optokoppler o. Ä.

Der Stromkreis umfasst Konstantstromquellen 54, 55, die jeweils dazu ausgebildet sind, ihre Spannung bei sich veränderndem Widerstand im Stromkreis so anzupassen, dass ein konstanter Strom fließt. Änderung des Widerstandes (Kommunikation: Controller 57 an Sensor 10) reguliert die Konstantstromquelle 54 auf eine konstante Stromstärke, sodass die über das Spannungsmessgerät 56 gemessene Spannung sich ändert.

Wird eine weitere Konstantstromquelle 55 hinzugeschaltet, so kann auch die Stromstärke moduliert werden, d.h. die Spannung bleibt nicht konstant (Kommunikation: Sensor an Controller). Die Änderung der an den Stromkreis angelegten Spannung kann durch das Spannungsmessgerät 58 ermittelt werden.

Über einen Ausgang 60 können somit die Zustände der einzelnen Sensoren oder sonstige Daten der Sensoren ausgegeben werden. Über den Mikrocontroller 57 wird entsprechend den Sensoren das Relais 59 gesteuert.

In Figur 16 ist eine Schalteinheit 12'' dargestellt, wie z.B. auch in Figur 9 als Schalteinheit 12 oder in Figur 10 als Schalteinheit 12' dargestellt ist. Die Schalteinheit 12' umfasst noch eine Spannungsquelle. Die Schalteinheit 12 aus Figur 9 umfasst insbesondere noch die Funktion eines Relais, das bei Leitungsunterbrechung auch den Motor M abschalten kann. Die Schalteinheit 12 ist in Figur 16 mit einem (zweiten) Sicherheitskreis 14 verbunden.

### Bezugszeichenliste:

- 1: Sensor
- 1': Sensor
- 2: Kontaktnehmer
- 3: Kontaktbrücke
- 3': Kontaktbrücke
- 4: Sender
- 4': Lichtleitereingang
- 5: Empfänger
- 5': Lichtleiterausgang
- 6: Trennsteg
- 7: Montageeinheit
- 8: Montageeinheit
- 9: Reflexionsfläche
- 9a: Reflexionsfläche
- 9b: Reflexionsfläche
- 9c: Reflexionsfläche
- 10: optischer Sensor
- 11: elektromechanischer Öffnungsschalter
- 12: Schalteinheit
- 12': Schalteinheit (mit Spannungsquelle)
- 12'': Schalteinheit
- 13: Spannungsquelle
- 14: Zweiter Sicherheitskreis
- 15: Schütz / Relais
- 16: Erster Sicherheitskreis
- 20: Bus
- 21: Optischer Sensor mit Elektronikeinheit
- 25: Schalteinheit
- 26: Sicherheitskreis
- 27: Schalteinheit mit integriertem Schütz
- 30: Schaltplan
- 41: Sensor
- 42: Kontaktnehmer
- 43: Kontaktbrücke
- 44: Lichtleiter
- 45: Sender
- 46: Empfänger
- 50: Kommunikationseinheit
- 51: Kommunikationseinheit
- 52: veränderbarer Widerstand
- 53: veränderbarer Widerstand
- 54: Konstantstromquelle
- 55: Konstantstromquelle
- 56: Spannungsmessgerät
- 57: Mikrocontroller der Schalteinheit
- 58: Spannungsmessgerät
- 59: Relais
- 60: Ausgang
- A: Ansicht zu erstem Zeitpunkt
- B: Ansicht zu zweitem Zeitpunkt
- C: Ansicht zu drittem Zeitpunkt
- D: Ansicht zu viertem Zeitpunkt
- K: Kabel / Stromleitung
- L: Lichtleiter
- M: Antriebsmotor
- µC: Mikrocontroller eines Sensors
- U: Unterbrechung

## Patentansprüche

1. schaltungseinrichtung, welche wenigstens zwei Sensoren (1, 1', 10, 21, 41) zur Detektion umfasst, welche in Abhängigkeit von der Detektion zwischen wenigstens zwei Schaltzuständen schaltbar ist, und wobei eine Schalteinheit (12, 12', 12'', 25, 27) vorhanden ist, **dadurch gekennzeichnet, dass** die Schalteinheit und die wenigstens zwei Sensoren jeweils eine Kommunikationseinheit (50, 51) zur Kommunikation untereinander aufweisen und die Schalteinheit in Abhängigkeit von den wenigstens zwei Sensoren schaltbar ist, wobei die Sensoren und die Schalteinheit in Reihe geschaltet sind und die Kommunikationseinheiten der Sensoren dazu ausgebildet sind, zur Informationsübertragung den Eigenwiderstand des Sensors zu modulieren, sodass jeder Sensor individuell mit der Schalteinheit kommunizieren und Informationen übermitteln bzw. austauschen kann.

2. Schaltungseinrichtung nach einem der vorgenannten Ansprüche, **dadurch gekennzeichnet, dass** die Kommunikationseinheit der Schalteinheit dazu ausgebildet ist, zur Informationsübertragung die Stromstärke und/oder die Spannung in der Schaltungseinrichtung zu modulieren.

3. Schaltungseinrichtung nach einem der vorgenannten Ansprüche, **dadurch gekennzeichnet, dass** die Schalteinheit eine Konstantstromquelle (54, 55) umfasst, die dazu ausgebildet ist, bei sich veränderndem Leitungswiderstand die Stromstärke durch Veränderung der Spannung entsprechend anzupassen.

4. Schaltungseinrichtung nach einem der vorgenannten Ansprüche, **dadurch gekennzeichnet, dass** die Schalteinheit wenigstens zwei parallel geschaltete Konstantstromquellen aufweist.

5. Schaltungseinrichtung nach einem der vorgenannter. Ansprüche, **dadurch gekennzeichnet, dass** wenigstens einer der Sensoren und/oder die Schalteinheit eine Messeinheit (56, 58) zur Messung der Modulation der Spannung und/oder der Stromstärke und/oder des Widerstandes aufweist.

6. Schaltungseinrichtung nach einem der vorgenannten Ansprüche, **dadurch gekennzeichnet, dass** wenigstens einer der Sensoren und die Schalteinheit dazu ausgebildet sind, die Informationsübertragung zwischen dem wenigstens einen Sensoren und der Schalteinheit wechselseitig durch Modulation der Stromstärke und durch Modulation der Spannung vorzunehmen.

7. schaltungseinrichtung nach einem der vorgenannten Ansprüche, **dadurch gekennzeichnet, dass** wenigstens einer der Sensoren und die Schalteinheit dazu ausgebildet sind, die Informationsübertragung von den wenigstens einem Sensoren zur Schalteinheit durch Modulation der Spannung vorzunehmen und die Informationsübertragung von der Schalteinheit zu den wenigstens einen Sensoren durch Modulation der Stromstärke vorzunehmen.

8. Sicherungsvorrichtung für Aufzugvorrichtungen, die über einen Antrieb eine Kabine verfahren können, mit einem Sicherheitskreis und einer Unterbrechungsvorrichtung zum Unterbrechen des Antriebs in Abhängigkeit vom Leitungszustand des Sicherheitskreises, **dadurch gekennzeichnet, dass** eine Schaltungseinrichtung nach einem der vorgenannten Ansprüche vorgesehen ist und die Sensoren in Abhängigkeit vom Schließzustand der Aufzugstür zwischen wenigstens zwei Schaltzuständen schaltbar sind, und wobei die Schalteinheit in Abhängigkeit vom Schaltzustand der Sensoren zwischen einem geschlossenen und einem geöffneten Leitungszustand schaltbar ist.

9. Aufzugvorrichtung mit einer Kabine und wenigstens einer Aufzugtür zum Öffnen und/oder Verschließen der Kabine sowie mit einer Sicherungsvorrichtung zur Verriegelung der Aufzugtür während des Betriebes, **dadurch gekennzeichnet, dass** die Sicherungsvorrichtung nach Anspruch 8 ausgebildet ist.

## Claims

1. Circuit device which comprises at least two sensors (1, 1', 10, 21, 41) for detection purposes, which can be switched between at least two switching states as a function of the detection and in which a switching unit (12, 12', 12", 25, 27) is provided, **characterised in that** the switching unit and the at least two sensors each comprise a communication unit (50, 51) for communicating with one another and the switching unit can be switched as a function of the at least two sensors, wherein the sensors and the switching unit are connected in series and the communication units of the sensors are configured to modulate the internal resistance of the sensor for the transmission of information, so that each sensor can communicate individually with the switching unit and can transmit or exchange information.

2. Circuit device according to one of the preceding claims, **characterised in that** the communication unit of the switching unit is also configured to modulate the current and/or the voltage in the circuit device for the transmission of information.

3. Circuit device according to one of the preceding claims, **characterised in that** the switching unit comprises a constant power source (54, 55) which is configured in the case of variable line resistance to adjust the current by changing the voltage accordingly.

4. Circuit device according to one of the preceding claims, **characterised in that** the switching unit has at least two parallel connected constant power sources.

5. Circuit device according to one of the preceding claims, **characterised in that** at least one of the sensors and/or the switching unit comprises a measuring unit (56, 58) for measuring the modulation of the voltage and/or the current and/or the resistance.

6. Circuit device according to one of the preceding claims, **characterised in that** at least one of the sensors and the switching unit are configured to transmit information reciprocally between the at least one sensor and the switching unit by modulating the current and by modulating the voltage.

7. Circuit device according to one of the preceding claims, **characterised in that** at least one of the sensors and the switching unit are configured to transmit information from the at least one sensor to the switching unit by modulating the voltage and to transmit information from the switching unit to the at least one sensor by modulating the current.

8. Safety device for lift devices that can move a cab by means of a drive, comprising a safety circuit and a disconnection device for disconnecting the drive as a function of the line status of the safety circuit, **characterised in that** a circuit device according to one of the preceding claims is provided and the sensors can be switched between at least two switching states as a function of the closed state of the lift door, and **in that** the switching unit can be switched between a closed and an open line status as a function of the switching state of the sensors.

9. Lift device comprising a cab and at least one lift door for opening and/or closing the cab and comprising a safety device for locking the lift door during operation, **characterised in that** the safety device is configured according to claim 8.

## Revendications

1. Dispositif de commutation, lequel comporte au moins deux capteurs (1, 1', 10, 21, 41) pour une détection, lequel peut être commuté en fonction de la détection entre au moins deux états de commutation, et une unité de commutation (12, 12', 12", 25, 27) étant présente, **caractérisé en ce que** l'unité de commutation et les au moins deux capteurs comprennent chacun une unité de communication (50, 51) permettant de les faire communiquer entre eux et l'unité de commutation peut être commutée en fonction des au moins deux capteurs, les capteurs et l'unité de commutation étant montés en série et les unités de communication des capteurs étant conçus pour moduler la résistance interne du capteur afin de transmettre des informations, de sorte que chaque capteur peut communiquer individuellement avec l'unité de commutation et transmettre ou échanger des informations.

2. Dispositif de commutation selon l'une des revendications précédentes, **caractérisé en ce que** l'unité de communication de l'unité de commutation est conçue pour moduler l'intensité du courant et/ou la tension dans le dispositif de commutation afin de transmettre des informations.

3. Dispositif de commutation selon l'une des revendications précédentes, **caractérisé en ce que** l'unité de commutation comporte une source de courant constant (54, 55) qui est conçue, en cas de résistivité du circuit modifiée, pour adapter en conséquence l'intensité du courant par une modification de la tension.

4. Dispositif de commutation selon l'une des revendications précédentes, **caractérisé en ce que** l'unité de commutation comprend au moins deux sources de courant constant montées en parallèle.

5. Dispositif de commutation selon l'une des revendications précédentes, **caractérisé en ce qu'**au moins un des capteurs et/ou l'unité de commutation comprennent une unité de mesure (56, 58) pour mesurer la modulation de la tension et/ou de l'intensité du courant et/ou de la résistance.

6. Dispositif de commutation selon l'une des revendications précédentes, **caractérisé en ce qu'**au moins un des capteurs et l'unité de commutation sont conçus pour assurer la transmission mutuelle d'informations entre le ou moins un capteur et l'unité de commutation par modulation de l'intensité du courant et par modulation de la tension.

7. Dispositif de commutation selon l'une des revendications précédentes, **caractérisé en ce qu'**au moins un des capteurs et l'unité de commutation sont conçus assurer la transmission d'informations du au moins un capteur à l'unité de commutation par modulation de la tension et la transmission d'informations de l'unité de commutation à l'au moins un capteur par modulation de l'intensité du courant.

8. Dispositif de sécurisation pour dispositifs d'ascenseur qui peuvent déplacer une cabine par l'intermédiaire d'un entraînement, comprenant un circuit de sécurité et un dispositif d'interruption pour interrompre l'entraînement en fonction de l'état de conduction du circuit de sécurité, **caractérisé en ce qu'**un dispositif de commutation selon l'une des revendications précédentes est prévu et **en ce que** les capteurs peuvent être commutés en fonction de l'état de fermeture de la porte d'ascenseur entre au moins deux états de commutation, et l'unité de commutation pouvant être commutée en fonction de l'état de commutation des capteurs entre un état de conduction fermé et un état de conduction ouvert.

9. Dispositif d'ascenseur comprenant une cabine et au moins une porte d'ascenseur pour ouvrir et/ou fermer la cabine et ainsi qu'un dispositif de sécurisation pour verrouiller la porte d'ascenseur pendant le fonctionnement, **caractérisé en ce que** le dispositif de sécurisation est configuré selon la revendication 8.
